# EUROPEAN PATENT APPLICATION

(11) **EP 4 848 194 A1**
(43) Date of publication of application: **02.12.2026**
(21) Application number: 25863931.9
(22) Date of filing: 21.08.2025
(51) Int. Cl.: G06Q 50/40, G06Q 30/01, B60L 58/16, B60L 58/12, G01R 31/396, G01R 31/382, G01R 31/392

(54) **ELECTRONIC DEVICE AND CERTIFICATE ISSUING METHOD THEREOF**

(30) Priority: 03.09.2024 KR 20240119539
(71) Applicant: LG Energy Solution, Ltd., Seoul 07335 (KR)
(72) Inventor: JO, Jeongjae, Daejeon 34122 (KR); BAEK, Jongshik, Daejeon 34122 (KR)
(74) Representative: Goddar, Heinz J.
(86) International application number: PCT/KR2025/012713
(87) International publication number: WO 2026/054382

(57) **Abstract**

According to an embodiment disclosed in the present document, an electronic device may comprise: a communication circuit for communicating with a vehicle equipped with a battery and a terminal of a user; a memory for storing one or more instructions; and a processor, wherein the one or more instructions, when executed, cause the processor to: in response to receiving a start signal for issuing a certificate of the battery from the terminal of the user, set a mission progress state for issuing the certificate on the basis of battery data acquired from the vehicle; and on the basis of the mission progress state, provide, to the terminal of the user, at least a part of the certificate and a notification related to the issuance of the certificate.

## Description

This application claims the benefit of Korean Patent Application No. 10-2024-0119539, filed on September 3, 2024, in the Ministry of Korean Intellectual Property, the disclosure of which is incorporated herein by reference in its entirety.

### Technical Field

Example embodiments of the present disclosure relate to an electronic device and a certificate issuing method of the same.

### Background Art

Recently, the research and development of a secondary battery is actively conducted. Here, the secondary battery is a rechargeable and dischargeable battery, and the term thereof includes all of a conventional nickel-cadmium (Ni/Cd) battery, a nickel-metal hydride (Ni/MH) battery, and the like, and an up-to-date lithium-ion battery. Among secondary batteries, the lithium-ion battery has a higher energy density compared to the conventional Ni/Cd battery, Ni/MH battery, and the like. In addition, the lithium-ion battery may be manufactured to be small in size and light in weight and thus used as the power source of a mobile device. As the range of the use thereof expands to the power source of an electric vehicle recently, the lithium-ion battery is in the spotlight as a next generation energy storage medium.

When a battery mounted to the electric vehicle is mounted to a vehicle, the issuance of a certificate for precisely evaluating the status of the battery and certifying the same is increasingly required.

### Detailed Description of the Invention

### Technical Goals

Example embodiments of the present disclosure is to provide an electronic device, which may monitor a mission progress status for issuing a certificate in a progress of charging a vehicle, evaluate a status of a battery, and issue and manage the certificate, and a certificate issuing method therefor.

However, the goals to be achieved by example embodiments of the present disclosure are not limited to the objectives described above and other objects may be clearly understood from the following example embodiments by those skilled in the art.

### Technical solutions

According to an aspect, there is provided an electronic device including a communication circuit configured to communicate with a terminal of a user and a vehicle mounted with a battery, a memory configured to store one or more instructions, and a processor, and when the one or more instructions are executed, the processor is configured to, in response to a start signal for issuing a certificate of the battery being received from the terminal of the user, set a mission progress status, which is for issuing the certificate, based on battery data acquired from the vehicle, and provide at least a portion of a notification associated with issuing the certificate and the certificate to the terminal of the user based on the mission progress status.

The processor may be configured to set the mission progress status to an initial status when a status of the battery determined based on the battery data and a transmission status of the battery data satisfy a mission precondition, and transmit a first notification, which indicates that the status of the battery is not appropriate for issuing the certificate, to the terminal of the user when the mission precondition is not satisfied.

The mission precondition may include a condition that a difference between a time point of receiving the battery data and a current time point is within a preset time and that the status of the battery is a charging status.

The processor may be configured to set the mission progress status to a first status when the status of the battery satisfies a preset mission start condition in a state in which the mission progress status is the initial status.

The mission start condition may include a condition that a ratio of charge of the battery at a start of charging is less than or equal to a first value.

The processor may be configured to, in a state in which the mission progress status is the first status, set the mission progress status to a second status when the status of the battery satisfies a preset mission completion condition, and set the mission progress status to a third status when the status of the battery is maintained in a non-charging status for a predetermined time before satisfying the mission completion condition or when the status of the battery does not satisfy the mission completion condition before charging of the battery ends.

The processor may be configured to provide, to the terminal of the user, a second notification associated with failure of issuing the certificate when the mission progress status is the third status.

The mission start condition may include, when a charging mode for the battery is rapid charging, a condition that a ratio of charge of the battery is greater than or equal to a second value or that a reference time elapses from a time point at which the mission progress status enters into the first status, and, when the charging mode is slow charging, a condition that the ratio of charge of the battery is greater than or equal to a third value, and the second value may be set to be larger than the third value.

The processor may be configured to attempt to evaluate the battery based on the battery data in a state in which the mission progress status is the second status, set the mission progress status to a fourth status when evaluation of the battery succeeds, and set the mission progress status to the third status when the evaluation of the battery fails.

The processor may be configured to attempt to issue the certificate of the battery based on a result of evaluating the battery in a state in which the mission progress status is the fourth status, set the mission progress status to a fifth status when issuance of the certificate succeeds, and set the mission progress status to the third status when the issuance of the certificate fails.

The processor may be configured to provide, to the terminal of the user, the certificate and a third notification associated with success of issuing the certificate in a state in which the mission progress status is the fifth status.

The certificate may include an evaluation result in which a status of the battery is evaluated, a period of validity, and a unique certificate number.

According to another aspect, there is also provided a certificate issuing method for an electronic device, the certificate issuing method including receiving a start signal for issuing a certificate of the battery from the terminal of the user, setting a mission progress status, which is for issuing the certificate, based on battery data acquired from the vehicle, and providing at least a portion of a notification associated with issuing the certificate and the certificate to the terminal of the user based on the mission progress status.

### Effects of the Invention

An electronic device and a certificate issuing method for the same according to example embodiments of the present disclosure may monitor whether a condition for issuing a certificate is satisfied, further precisely evaluate a status of the battery, and issue the certificate for certifying the same.

Other various effects identified directly or indirectly through the present disclosure may be additionally provided.

### Brief Description of Drawings

FIG. 1 is a diagram illustrating a configuration of a system for issuing a certificate of a battery according to an example embodiment of the present disclosure.
FIG. 2 is a block diagram illustrating a configuration of an electronic device according to an example embodiment of the present disclosure.
FIG. 3 is a flow chart illustrating a process of issuing a certificate according to an example embodiment of the present disclosure.
FIG. 4 is a flowchart for describing a certificate issuing method according to an example embodiment of the present disclosure.

### Mode for Carrying Out the Invention

Hereinafter, various example embodiments of the present disclosure will be described with reference to the accompanying drawings. However, it should be understood that this is not to limit the present disclosure to a specific embodiment and various modifications, equivalents, and/or alternatives of the example embodiments of the present disclosure are included.

The singular form of a noun corresponding to an item in the present disclosure may include one item or a plural of items unless clearly described otherwise in context. In the present disclosure, expressions such as "A or B", "at least one of A and B", "at least one of A or B", "A, B, or C", "at least one of A, B, and C", and "at least one of A, B, or C" each may include one of the items listed together in the corresponding phrase among the expressions or all possible combinations thereof. Terms such as "first" or "second" may be used to simply distinguish the corresponding element from other elements and do not limit the corresponding elements in another aspect (e.g., importance or order). The case in which some element (e.g., a first element) is described as being "coupled" or "connected" to another element (e.g., a second element) with or without the term "functionally" or "communicatively", it is understood that the element may be connected to the other element directly (for example, in a wired manner), wirelessly, or through a third element.

Each of the elements described in the present disclosure (e.g., modules or programs) may include a single object or a plurality of objects. According to the various example embodiments, one or more elements or operations of the corresponding elements may be omitted, or one or more other elements or operations may be added. Alternatively or additionally, a plurality of elements (e.g., the modules or the programs) may be integrated into one element. In this case, the integrated element may perform one or more functions of each of the plurality of elements in a way identical or similar to the way in which a function is performed by the corresponding element among the plurality of elements before the integration. According to the various example embodiments, operations performed by a module, a program, or another element may be executed sequentially, in parallel, repeatedly, or heuristically. Alternatively, one or more of the operations may be executed in different order or omitted, or one or more other operations may be added thereto.

The term "module" or "unit", which is used in the present disclosure, may include a unit realized in hardware, software, or firmware and may be used to be interchangeable with a term such as logic, logic block, component, or circuit. A module may be an integrally formed component or a minimum unit or a portion of the component, which performs one or more functions. For example, according to an example embodiment, the module may be implemented in the form of an application-specific integrated circuit (ASIC).

The various example embodiments may be implemented as the software (e.g., a program or an application) including one or more instructions stored in a storage medium readable by a machine. For example, the processor of the machine may call at least one instruction among the one or more stored instructions from the storage medium and execute the at least one instruction. This allows the machine to be operated so as to perform at least one function according to the at least one called instruction. The at least one or more instructions may include code generate by a complier or code executable by an interpreter. The storage medium readable by the machine may be provided in the form of a non-transitory storage medium. Here, the term "non-transitory" merely means that the storage medium is tangible and does not include a signal (e.g., an electromagnetic wave). The term does not distinguish the case in which data is stored semi permanently in the storage medium and the case in which the data is stored temporarily therein.

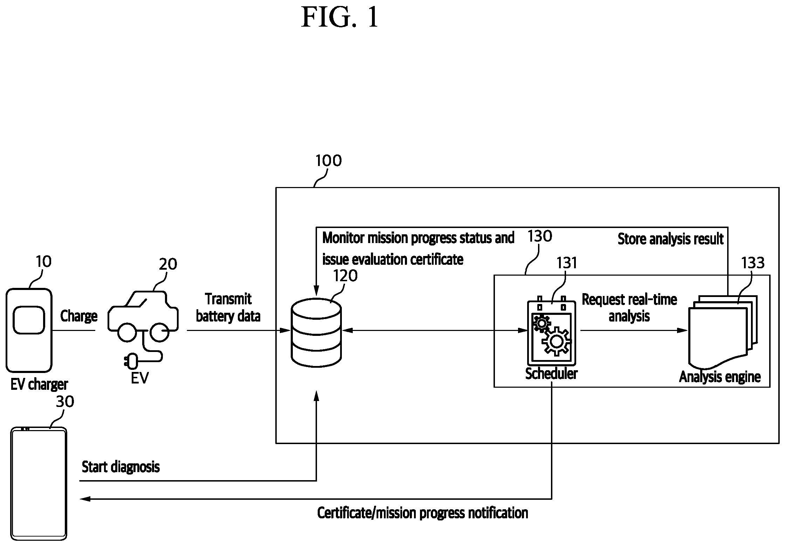

FIG. 1 is a diagram illustrating a configuration of a system for issuing a certificate of a battery according to an example embodiment of the present disclosure.

Referring to FIG. 1, a user of a vehicle 20 mounted with the battery may be issued with the certificate of the battery by using a terminal 30 of the user. For example, the user may be issued with the certificate of the battery during charging of the vehicle 20. The certificate of the battery may refer to a device for certifying a status of the battery by evaluating the status of the battery.

In order to evaluate the status of the battery mounted to the vehicle 20, battery data satisfying a predetermined charging condition may be required to be analyzed. Accordingly, the user may perform a mission for issuing the certificate of the battery during the charging of the vehicle 20. In addition, an electronic device 100 may further precisely evaluate the status of the battery by analyzing data satisfying a charging condition and provide the certificate for certifying the status of the battery to the user.

The certificate which is issued as such may be used to prove the status of the battery later. For example, the issued certificate may be used to prove the status of the battery in a sale of the vehicle 20. In some cases, forging of the certificate issued as such may prevented by using a blockchain technology.

The vehicle 20 may be an electric vehicle mounted with a battery. The vehicle 20 may be connected to a charger 10, so that the battery may be charged. In a process of charging the vehicle 20, battery data may be provided to the electronic device 100. Also, in the process of charging the vehicle 20, vehicle data such as traveling data recorded and stored in the vehicle 20 also may be provided to the electronic device 100 in addition to the battery data.

For example, an on-board diagnostics (OBD) device mounted to the vehicle 20 may collect and store in-vehicle battery data and/or the vehicle data, and the OBD device may provide the collected and stored data to the electronic device 100 by communicating with the electronic device 100.

The terminal 30 of the user may refer to a device carried or owned by the user. The terminal 30 of the user may include various forms of devices for performing data communication. For example, the terminal 30 of the user may include a mobile device such as a smartphone or a tablet computer, a computer device such as a desktop computer or a laptop computer, a multimedia device, a camera, a wearable device, and a virtual reality (VR) device and is not limited thereto. For example, the terminal 30 of the user may include a server or a gateway for transmitting a data packet through an application.

The user may be an owner or a possessor of the vehicle 20. The user may operate the terminal 30. For example, the user may perform an operation for issuing the certificate of the battery by using a web browser or an application in the terminal 30 of the user. Here, the application may be an application in which the user of the vehicle 20 may use a useful service associated with the battery. For example, the user may use the application to receive a variety of information on the battery mounted to the vehicle 20 (e.g., energy efficiency) or receive a variety of information on charging of the battery (e.g., a near charging station).

The user may use a certificate issuing service by using the application. For example, the user may click a start interface for issuing the certificate, which is provided through the application. In this case, the application may transmit a start signal for issuing the certificate to the electronic device 100 in response to an input on the start interface from the user.

According to an example embodiment, the start interface may be activated when a predetermined condition is satisfied. For example, in order to acquire sufficient data for issuing the certificate, the start interface may be activated exclusively when a ratio of charge of the battery at a start of the charging is less than or equal to a predetermined value.

According to an example embodiment, the application may be provided by an operation entity of the electronic device 100. For example, the user may perform, in the terminal 30 of the user, input for issuing the certificate by accessing the application provided by the operation entity of the electronic device 100 or may identify a notification or the issued certificate through a display of the terminal 30 of the user. However, it is merely an example, and an entity managing the application may be different from the electronic device 100. In this case, the electronic device 100 may provide the certificate and/or the notification to the terminal 30 of the user via the entity managing the application (e.g., a server).

The electronic device 100 may be, for example, a server connected to the vehicle 20 mounted with the battery. The electronic device 100 may provide the certificate associated with the battery mounted to the vehicle 20 and/or a notification associated with issuing the certificate to the terminal 30 of the user by communicating with the vehicle 20 and the terminal 30 of the user.

The electronic device 100 may acquire the battery from the vehicle 20, receive an input for issuing the certificate, and provide, to the terminal 30 of the user, at least a portion of the certificate and the notification associated with issuing the certificate. For example, in a process in which the charging of the battery is performed as the vehicle is connected to the charger 10, the user may perform the operation for issuing the certificate of the battery by using the terminal 30 of the user. For example, the user may access the application which is installed in the terminal 30 of the user and click a start button for issuing the certificate.

When receiving the start signal from the terminal 30 of the user, the electronic device 100 may perform a process for issuing the certificate. For example, the electronic device 100 may acquire data on a battery mounted to an electric vehicle 20 and store the data in a memory 120. In addition, a processor 130 may use the data on the battery, which is stored in the memory 120, to perform analysis of the status of the battery and may store a status analysis result back to the memory 120.

Also, the processor 130 may monitor, based on the status of the battery, a mission progress status for issuing the certificate and provide the certificate which is finally issued and/or a notification according to the mission progress status to the terminal 30 of the user. For example, the processor 130 may include a scheduler 131 and an analysis engine 133, and the scheduler 131 may monitor the mission progress status. Furthermore, the scheduler 131 may request battery evaluation by analyzing the battery data with the analysis engine 133 according to the mission progress status, and the analysis engine 133 may perform the battery evaluation.

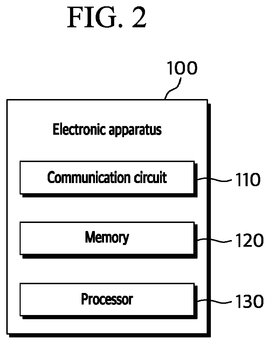

A detailed operation in which the electronic device 100 determines the mission progress status and provides the notification and/or the certificate will be described below with reference to FIG. 2.

FIG. 2 is a block diagram illustrating a configuration of the electronic device 100 according to an example embodiment of the present disclosure.

Referring to FIG. 2, the electronic device 100 may include a communication circuit 110, the memory 120, and the processor 130. At least one of elements included in an electronic device 100 may be omitted, or another element may be added to the electronic device 100. Additionally or alternatively, some elements may be integrally implemented or may be implemented as a single entity or multiple entities. At least some elements in the electronic device 100 may be integrally implemented or may be implemented as a single entity or multiple entities. The at least some elements in the electronic device 100 may be connected to each other through a bus, a general purpose input/output (GPIO), a serial peripheral interface (SPI), a mobile industry processor interface (MIPI), or the like and may send and receive data and/or a signal to and from each other.

The communication circuit 110 may establish a wired or wireless communication channel with an external device (e.g., the terminal 30 of a user or the vehicle 20) and transmit and receive a variety of data to and from the external device. The communication circuit 110 may include at least one port for connection to the external device through a wired cable in order to communicate with the external device in a wired manner. The communication circuit 110 may include a cellular communication module and may be configured to be connected to a cellular network (e.g., third generation (3G), long-term evolution (LTE), fifth generation (5G), wireless broadband (Wibro), or Worldwide Interoperability for Microwave Access (Wimax)). According to an example embodiment, the communication circuit 110 may include a near-field communication module to transmit and receive the data to and from the external device by using near field communication (e.g., wireless-fidelity (Wi-Fi), Bluetooth, Bluetooth Low Energy(BLE), or ultra-wideband (UWB)), but is not limited thereto.

For example, the communication circuit 110 may communicate with the vehicle 20 and the terminal 30 of the user. The communication circuit 110 may acquire battery data from the vehicle 20. For example, the communication circuit 110 may acquire the battery data in a process of charging the vehicle 20.

According to an example embodiment, the communication circuit 110 may acquire the battery data by communicating with an onboard diagnostic (OBD) device mounted to the electric vehicle 20. For example, the OBD device may collect and store in-vehicle battery data and transmit the collected data to the communication circuit 110. In some cases, the OBD device may further collect vehicle data as well as the battery data, and the communication circuit 110 may acquire the vehicle data collected by the OBD device.

Data on the battery may include, for example, an electric current, a voltage, a temperature, a state of charge (SOC), or the like of the battery and/or each of battery cells included in the battery.

In addition, the communication circuit 110 may receive a start signal for issuing a certificate from the terminal 30 of the user and transmit the certificate and/or a notification determined according to an operation of the processor 130 to the terminal 30 of the user.

The memory 120 may store a variety of data used by at least one element (e.g., the processor 130). The memory 120 may store instructions for the above-described operation of the processor 130. A program may be stored as software in the memory 120 and include, for example, an operating system, a middleware, or an application. Unless noted otherwise, the memory 120 in the present disclosure may refer to a set of one or more memories 120.

For example, the memory 120 may store the battery data which is acquired from the communication circuit 110 and store a result of evaluating the battery and information on the issued certificate according to the operation of the processor 130.

The processor 130 may be an element for performing operation or data processing for communication and/or control of each element of the electronic device 100 and may be operationally connected to elements of the electronic device 100. The processor 130 may load, into the memory 120, an instruction or data received from another element of the electronic device 100, process the instruction or the data stored in the memory 120, and store result data. Unless noted otherwise, the processor 130 in the present disclosure may refer to a set of one or more processors 130.

According to an example embodiment, the communication circuit 110 may receive the start signal for issuing the certificate of the battery from the terminal 30 of the user. The communication circuit 110 may operate with a trigger that is reception of the start signal from the terminal 30 of the user, which acts as a trigger for issuing the certificate of the battery.

According to an example embodiment, in response to the start signal being received from the terminal 30 of the user, the processor 130 may set a mission progress status for issuing the certificate and monitor the mission progress status. Here, the mission progress status may refer to an operation in which the processor 130 distinguishes between issuing processes for issuing the certificate, and the mission progress status may be set in course of an issuing process. The mission progress status may have a plurality of statuses. For example, the mission progress status may have the plurality of statuses throughout a start operation to a certificate issuing completion operation in a certificate issuing process.

According to an example embodiment, the processor 130 may set the mission progress status, which is for issuing the certificate, based on the battery data which is acquired from the vehicle 20. Precise evaluation of a status of the battery may be required in order to issue the certificate, and whether a predetermined condition is satisfied, such as sufficiently acquiring battery data that satisfies a condition, may be determined for the precise evaluation. In this regard, the processor 130 may set the mission progress status by determining whether conditions for issuing the certificate of the battery are satisfied. For example, the processor 130 may set the mission progress status by periodically inquiring into and analyzing the battery data which is acquired form the communication circuit 110 and stored in the memory 120 and monitor the mission progress status.

According to an example embodiment, the processor 130 may determine whether the status of the battery determined based on the battery data and a transmission status of the battery data satisfy a mission precondition. The mission precondition may refer to a basic condition to be satisfied for starting a mission for issuing the certificate.

For example, in order to issue the certificate of the battery, the battery data may be acquired from the vehicle 20, and satisfaction of a charging condition may be required for precisely evaluating the battery. Accordingly, the mission precondition according to an example embodiment may include a condition that a difference between a time point of receiving the battery data and a current time point is within a preset time and that the status of the battery is a charging status.

To this end, the processor 130 may determine the transmission status of the battery data and the charging status of the battery. For example, the processor 130 may determine the transmission status of the battery data based on whether the battery data is acquired from the communication circuit 110. Also, when the battery data is acquired, the processor 130 may determine the charging status of the battery from the acquired battery data. The charging status of the battery may include, for example, whether the battery is currently charged.

According to an example embodiment, the mission progress status may be set to an initial status when the status of the battery and the transmission status of the battery data satisfy the mission precondition. When the mission precondition is satisfied, the process may determine that the basic condition for issuing the certificate is satisfied and may set the mission progress status to the initial status in order to issue the certificate. For example, when the difference between the time point of receiving the data and the current time point is within the preset time, and when the status of the battery is the charging status, the processor 130 may set the mission progress status to the initial status as determining that the battery data is normally transmitted in a process of charging.

According to an example embodiment, when the transmission status of the battery data and the status of the battery do not satisfy the mission precondition, the processor 130 may end the certificate issuing process as determining that the basic condition for issuing the certificate is not satisfied. For example, when the difference between the time point of receiving the battery data and the current time point exceeds the preset time, the processor 130 may end the certificate issuing process as determining that the transmission status of the data is abnormal. The preset time may be set to, for example, 10 minutes.

According to an example embodiment, the processor 130 may change the mission progress status to a first status when the status of the battery satisfies a preset mission start condition in a state in which the mission progress status is the initial status. The first status may refer to, for example, a status in which the mission for issuing the certificate is prepared to be performed.

According to an example embodiment, the mission start condition may include a condition that a ratio of charge (e.g., state of charge (SOC)) of the battery at a start of the charging is less than or equal to a first value. For example, the processor 130 may determine whether the ratio of charge of the battery at the start of the charging is less than or equal to the first value by identifying the battery data which is acquired from the communication circuit 110.

The status of the battery may be required to be analyzed in order to issue the certificate of the battery, and an environment for acquiring sufficient battery data may be prepared in order to analyze the status of the battery. In this regard, the mission start condition may include the condition that the ratio of charge (e.g., SOC) at the start of charging the battery is less than or equal to the first value so that the sufficient battery data is acquired in order that the electronic device 100 analyzes the status of the battery.

For example, when the ratio of charge of the battery at the start of the charging is high, the battery data in the process of the charging may be insufficient even if the battery is fully charged, and the battery data may be difficult to secure in a predetermined SOC range. Thus, the mission start condition may be set to the condition that the ratio of charge (e.g., SOC) of the battery at the start of the charging is less than or equal to the first value. For example, the first value may be set to 30%.

According to an example embodiment, when the ratio of charge of the battery at the start of charging exceeds the first value, the processor 130 may inactivate an input on a start interface, for issuing the certificate, of an application provided to the terminal 30 of the user. In this case, the user may use a certificate issuing service exclusively when the ratio of charge of the battery at the start of the charging is less than or equal to the first value.

According to an example embodiment, the processor 130 may change the mission progress status to a second status when the status of the battery satisfies a preset mission completion condition in a state in which the mission progress status is the first status. The second status may refer to, for example, a status in which the battery is evaluable as the sufficient battery data is acquired. In order to determine whether the sufficient data for evaluating the battery is secured, the processor 130 may determine whether the status of the battery satisfies the preset mission completion condition.

According to an example embodiment, the mission completion condition may be set variously depending on a charging scheme for the battery. The charging scheme for the battery may include rapid charging and slow charging. Since a time required for charging the battery may vary depending on the charging scheme for the battery, and since a time of acquiring the data may vary depending on the charging scheme for the battery, the mission completion condition may be set variously depending on the charging scheme.

According to an example embodiment, when the charging scheme for the battery is the rapid charging, the mission completion condition may include a condition that a ratio of charge of the battery is greater than or equal to a second value or that a reference time elapses from a time point at which the mission progress status enters into the first status.

Setting the mission completion condition may be understood as being for securing the battery data sufficient to evaluate the battery. In a case of the rapid charging, since the ratio of charge of the battery may rapidly increase compared to the slow charging, the battery data for evaluating the battery may not be sufficiently secured when the charging ends in a short period. Thus, when the charging scheme for the battery is the rapid charging, in order to secure the sufficient battery data, the mission completion condition may be set to the condition that the ratio of charge of the battery is greater than or equal to the second value or that the reference time elapses from the time point at which the mission progress status enters into the first status. For example, the second value may be set to 90%, and the reference time may be set to 30 minutes.

According to an example embodiment, when the charging scheme for the battery is the slow charging, the mission completion condition may include a condition that the ratio of charge of the battery is greater than or equal to a third value. In a case of the slow charging, since a time for acquiring the battery data may be additionally secured because a charging rate is lower than that of the rapid charging, the mission completion condition may be set to the condition that the ratio of charge of the battery is greater than or equal to the third value.

According to an example embodiment, the second value may be set to be larger than the third value. Since the rapid charging has a charging rate faster than that of the slow charging, the second value may be set to be larger than the third value so that the sufficient data is secured.

According to an example embodiment, the processor 130 may change the mission progress status to a third status when the status of the battery is maintained in a non-charging status for a predetermined time before satisfying the mission completion condition or when the status of the battery does not satisfy the mission completion condition before the charging of the battery ends. The third status may refer to a status in which issuance of the certificate fails. The predetermined time may be set to, for example, 5 minutes.

When acquisition of the battery data is stopped in the process of the charging (e.g., entering into the non-charging status) before the sufficient data for evaluating the battery is acquired, or when the mission completion condition is not satisfied until the charging is completed, since the battery data for evaluating the battery is insufficient, the processor 130 may change the mission progress status to the third status.

According to an example embodiment, the processor 130 may attempt to evaluate the battery based on the battery data when the mission progress status is the second status. For example, the processor 130 may attempt to evaluate the battery by using the analysis engine 133 which is stored in the memory 120.

The processor 130 may perform evaluation of the battery by diagnosing the status of the battery with the battery data. For example, the processor 130 may evaluate the battery by using the battery data such as a temperature, an SOC, an electric current, a voltage, power, or an accumulated amount of charge and discharge of the battery.

The processor 130 may evaluate various evaluation factors of the battery by using the battery data. For example, the evaluation factors of the battery may include a state of health (SOH) a remaining using life (RUL), a maximum voltage, a minimum voltage, an average temperature, energy efficiency, a charge and discharge current, and the like of the battery.

For example, the processor 130 may evaluate the battery by analyzing the battery data which is acquired between a time point of starting the charging of the battery and a time point at which the mission completion condition is satisfied. In some cases, in order to further precisely evaluate the battery, the processor 130 may further use data stored in the OBD device, which is before a time point of the charging.

The processor 130 may change the mission progress status to a fourth status when the evaluation of the battery succeeds. The processor 130 may change the mission progress status to the fourth status when a result of evaluating the battery evaluation factors is drawn by analyzing the battery data. The fourth status may refer to, for example, a preparation status for issuing the certificate.

The processor 130 may change the mission progress status to the third status when the evaluation of the battery fails. For example, the processor 130 may fail in the evaluation of the battery when the acquired battery data omits attribute data for evaluating a predetermined evaluation factor or when logging data is imperfect because a storage device of the OBD device is abnormal.

According to an example embodiment, the processor 130 may attempt to issue the certificate based on the result of evaluating the battery when the mission progress status is the fourth status. The processor 130 may issue the certificate of the battery when the result of evaluating the evaluation factors of the battery is drawn to be all normal. The processor 130 may change the mission progress status to a fifth status when the issuance of the certificate succeeds. The fifth status may be a status for issuing the certificate.

The processor 130 may change the mission progress status to the third status when the issuance of the certificate fails. For example, the processor 130 may determine failure of issuing the certificate when a result of evaluating some factors among the evaluation factors of the battery is missing.

According to an example embodiment, the processor 130 may provide a portion of a notification associated with issuing the certificate and the certificate to the terminal 30 of the user based on the mission progress status.

According to an example embodiment, the processor 130 may provide a first notification, which indicates that the status of the battery is not appropriate for issuing the certificate, to the terminal 30 of the user when the transmission status of the battery data and the status of the battery do not satisfy the mission precondition.

The first notification may be a notification for notifying the user that a current status is not appropriate for issuing the certificate. For example, the processor 130 may provide, to the terminal 30 of the user, the first notification which includes a phrase such as "Vehicle is not currently charged".

According to an example embodiment, the processor 130 may provide, to the terminal 30 of the user, a second notification associated with the failure of issuing the certificate when the mission progress status is the third status. The second notification may include information indicating that the issuance of the certificate has failed. For example, the processor 130 may provide, to the terminal 30 of the user, the second notification which includes a phrase indicating that the issuance of the certificate has failed.

According to an example embodiment, the processor 130 may analyze a reason for which the mission progress status is set to the third status when setting the mission progress status to the third status and provide the second notification which includes the reason for setting to the third status, namely, a mission progress failure reason, and/or a guide for mission success.

For example, when the mission progress status is set to the third status because the status of the battery is maintained in the non-charging status for the predetermined time in the state in which the mission progress status is the first status, the second information may include information indicating that the non-charging status has continued for the predetermined time.

According to an example embodiment, before providing the second notification, the processor 130 may further provide a warning notification indicating that the issuance of the certificate may fail to the terminal 30 of the user. For example, when the status of the battery is maintained in the non-charging status for 1 minute or more in the state in which the mission progress status is the first status, the processor 130 may provide the warning notification, which indicates that the issuance of the certificate may fail when the non-charging status continues for 4 minutes, to the terminal 30 of the user.

According to an example embodiment, when the mission progress status is the fifth status, the processor 130 may provide, to the terminal 30 of the user, the certificate and a third notification associated with success of issuing the certificate. The third notification may refer to a notification that the issuance of the certificate succeeds. The user may identify the third notification provided to the terminal 30 of the user and identify the issued certificate.

According to an example embodiment, the certificate may include an evaluation result in which the status of the battery is evaluated, a period of validity, and a unique certificate number. The evaluation result in which the status of the battery is evaluated may include the result of evaluating the evaluation factors as described above. For example, the certificate of the battery may include information such as current performance compared to that at release, a distribution of battery performance, a distribution of energy efficiency, a range of maximum/minimum performance, or a change in an electric current and a voltage in the process of charging. The certificate which is issued as such may be used to prove the status of the battery later.

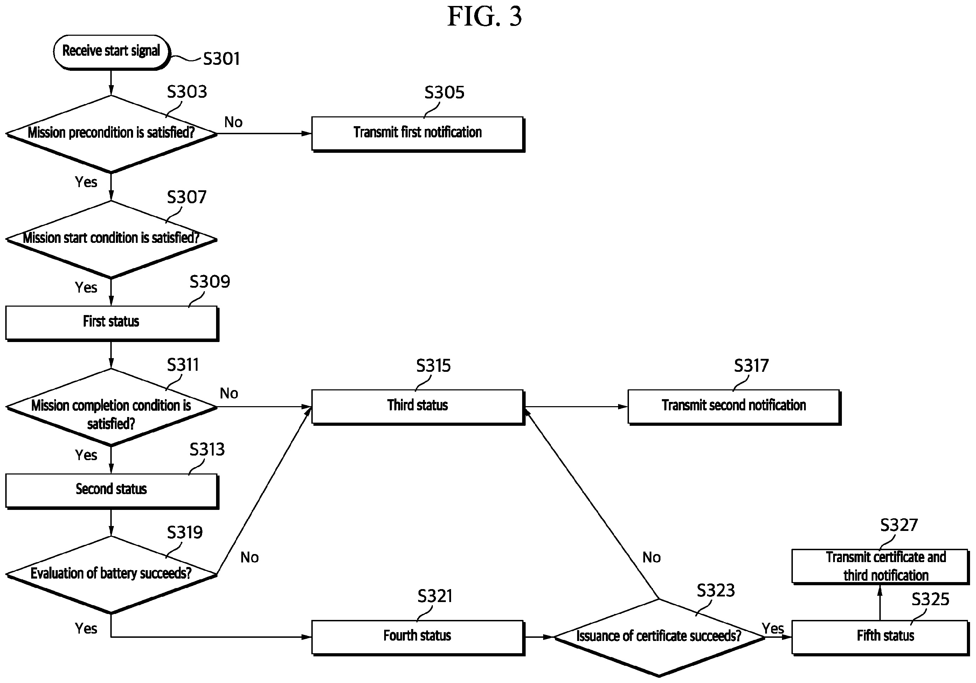

FIG. 3 is a flow chart illustrating a process of issuing a certificate according to an example embodiment of the present disclosure.

Referring to FIG. 3, in operation S301, the electronic device 100 may receive a start signal from the terminal 30 of a user. For example, the user may perform input on a start interface for issuing a certificate of a battery, and the terminal 30 of the user may transmit the start signal to the electronic device 100 in response to an input from the user.

In operation S303, the processor 130 may determine whether a mission precondition for issuing the certificate is satisfied. The mission precondition may be determined based on a transmission status of battery data and a status of the battery. For example, the mission precondition may include a condition that a difference between a time point of receiving the battery data and a current time point is within a preset time and that the status of the battery is a charging status.

When the mission precondition is satisfied (e.g., operation S303 - Yes), the processor 130 may set a mission progress status to an initial status and proceed to operation S307. When the mission precondition is not satisfied (e.g., operation S303 - No), the processor 130 may proceed to operation S305.

In operation S305, the processor 130 may transmit a first notification to the terminal 30 of the user. The first notification may include a notification indicating that issuance of the certificate is not appropriate. The processor 130 may provide the first notification to the terminal 30 of the user and end a certificate issuing process.

In operation S307, the processor 130 may determine whether the status of the battery satisfies a mission start condition is satisfied. When the status of the battery satisfies the mission start condition (e.g., operation S307 - Yes), the processor 130 may proceed to operation S309. For example, the mission start condition may include a condition that a ratio of charge of the battery at a start of charging is less than or equal to a first value. In an example embodiment, the start signal may be received exclusively when the ratio of charge of the battery at the start of the charging is less than or equal to the first value.

In operation S309, when the status of the battery satisfies the mission start condition, the processor 130 may set the mission progress status to a first status. The first status may refer to, for example, a status in which a mission for issuing the certificate is prepared to be performed.

In operation S311, in a state in which the mission progress status is the first status, the processor 130 may determine whether the status of the battery satisfies a mission completion condition is satisfied. When the status of the battery satisfies the mission completion condition (e.g., operation S311 - Yes), the processor 130 may proceed to operation S313. When the status of the battery does not satisfy the mission completion condition (e.g., operation S311 - No), the processor 130 may proceed to operation S315. The mission completion condition may be set variously depending on a charging scheme for the battery.

In operation S313, when the status of the battery satisfies the mission completion condition, the processor 130 may set the mission progress status to a second status. The second status may refer to, for example, a status in which the battery is evaluable as the sufficient battery data is acquired.

In operation S315, when the status of the battery does not satisfy the mission completion condition, the processor 130 may set the mission progress status to a third status. The third status may refer to a status in which the issuance of the certificate fails.

In operation S317, the processor 130 may transmit a second notification to the terminal 30 of the user. The second notification may include information indicating that the issuance of the certificate has failed. The processor 130 may provide the second notification to the terminal 30 of the user and end the certificate issuing process.

In operation S319, the processor 130 may attempt to evaluate the battery. When evaluation of the battery succeeds (e.g., operation S319 - Yes), the processor 130 may proceed to operation S321. When the evaluation of the battery fails (e.g., operation S319 - No), the processor 130 may proceed to operation S315.

In operation S321, the processor 130 may change the mission progress status to a fourth status when the evaluation of the battery succeeds. The fourth status may refer to, for example, a preparation status for issuing the certificate.

In operation S323, the processor 130 may attempt to issue the certificate. When the issuance of the battery succeeds (e.g., operation S323 - Yes), the processor 130 may proceed to operation S325. When the issuance of the battery fails (e.g., operation S323 - No), the processor 130 may proceed to operation S315.

In operation S325, the processor 130 may change the mission progress status to a fifth status when the issuance of the certificate succeeds. The fifth status may refer to, for example, a status for issuing the certificate.

In operation S327, the processor 130 may transmit the certificate and a third notification to the terminal 30 of the user. The third notification may refer to a notification that the issuance of the certificate succeeds. The processor 130 may provide the certificate and the third notification to the terminal 30 of the user and end the certificate issuing process.

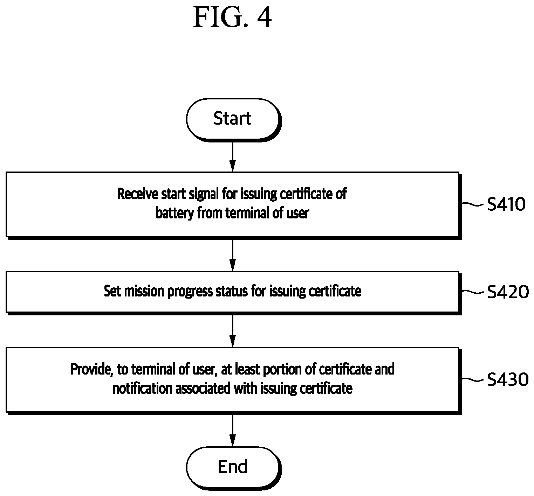

FIG. 4 is a flowchart for describing a certificate issuing method according to an example embodiment of the present disclosure.

Referring to FIG. 4, in operation S410, the electronic device 100 may receive a start signal for issuing a certificate of a battery from the terminal 30 of a user. For example, the user may access an application for issuing the certificate, which is installed to the terminal 30 of the user, and click a start button, and the application may transmit the start signal to the electronic device 100 in response to a click on the start button by the user.

In operation S420, the electronic device 100 may set a mission progress status for issuing the certificate. The electronic device 100 may set the mission progress status based on battery data. According to an example embodiment, the mission progress status may have five statuses of first to fifth statuses, and the processor 130 may perform different operations depending on the mission progress status.

In operation S430, the electronic device 100 may provide a portion of a notification associated with issuing the certificate and the certificate to the terminal 30 of the user. The processor 130 may provide different notifications and the certificate to the terminal 30 of the user based on the mission progress status. As an example, the electronic device 100 may provide a second notification to the terminal 30 of the user in a state in which the mission progress status is a third status. As another example, the electronic device 100 may provide a third notification to the terminal 30 of the user in a state in which the mission progress status is a fifth status.

The present specification and drawings have been described with respect to the example embodiments of the present disclosure. Although specific terms are used, it is only used in a general sense to easily explain the technical content of the present disclosure and to help the understanding of the invention, and is not intended to limit the scope of the specification. It will be apparent to those skilled in the art that other modifications based on the technical spirit of the present disclosure may be implemented in addition to the embodiments disclosed herein.

An device or terminal according to the above-described example embodiments may include a processor, a memory that stores and executes program data, a permanent storage such as a disk drive, a communication port for communicating with an external device, and a user object device such as a touch panel, a key, and a button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include the meaning of a series of routines of software in association with a processor.

## Claims

1. An electronic device comprising:
a communication circuit configured to communicate with a terminal of a user and a vehicle mounted with a battery;
a memory configured to store one or more instructions; and
a processor,
wherein when the one or more instructions are executed, the processor is configured to, in response to a start signal for issuing a certificate of the battery being received from the terminal of the user:
set a mission progress status, which is for issuing the certificate, based on battery data acquired from the vehicle; and
provide at least a portion of a notification associated with issuing the certificate and the certificate to the terminal of the user based on the mission progress status.

2. The electronic device of claim 1, wherein the processor is configured to:
set the mission progress status to an initial status when a status of the battery determined based on the battery data and a transmission status of the battery data satisfy a mission precondition; and
transmit a first notification, which indicates that the status of the battery is not appropriate for issuing the certificate, to the terminal of the user when the mission precondition is not satisfied.

3. The electronic device of claim 2, wherein the mission precondition includes a condition that a difference between a time point of receiving the battery data and a current time point is within a preset time and that the status of the battery is a charging status.

4. The electronic device of claim 2, wherein the processor is configured to set the mission progress status to a first status when the status of the battery satisfies a preset mission start condition in a state in which the mission progress status is the initial status.

5. The electronic device of claim 4, wherein the mission start condition includes a condition that a ratio of charge of the battery at a start of charging is less than or equal to a first value.

6. The electronic device of claim 4, wherein the processor is configured to, in a state in which the mission progress status is the first status:
set the mission progress status to a second status
when the status of the battery satisfies a preset mission completion condition; and
set the mission progress status to a third status when the status of the battery is maintained in a non-charging status for a predetermined time before satisfying the mission completion condition or when the status of the battery does not satisfy the mission completion condition before charging of the battery ends.

7. The electronic device of claim 6, wherein the processor is configured to provide, to the terminal of the user, a second notification associated with failure of issuing the certificate when the mission progress status is the third status.

8. The electronic device of claim 6, wherein the mission start condition includes:
when a charging scheme for the battery is rapid charging, a condition that a ratio of charge of the battery is greater than or equal to a second value or that a reference time elapses from a time point at which the mission progress status enters into the first status; and
when the charging scheme is slow charging, a condition that the ratio of charge of the battery is greater than or equal to a third value, and
the second value is set to be larger than the third value.

9. The electronic device of claim 6, wherein the processor is configured to:
attempt to evaluate the battery based on the battery data in a state in which the mission progress status is the second status;
set the mission progress status to a fourth status when evaluation of the battery succeeds; and
set the mission progress status to the third status when the evaluation of the battery fails.

10. The electronic device of claim 9, wherein the processor is configured to:
attempt to issue the certificate of the battery based on a result of evaluating the battery in a state in which the mission progress status is the fourth status;
set the mission progress status to a fifth status when issuance of the certificate succeeds; and
set the mission progress status to the third status when the issuance of the certificate fails.

11. The electronic device of claim 10, wherein the processor is configured to provide, to the terminal of the user, the certificate and a third notification associated with success of issuing the certificate in a state in which the mission progress status is the fifth status.

12. The electronic device of claim 1, wherein the certificate comprises an evaluation result in which a status of the battery is evaluated, a period of validity, and a unique certificate number.

13. A certificate issuing method for an electronic device including a communication circuit configured to communicate with a terminal of a user and a vehicle mounted with a battery, a memory configured to store one or more instructions, and a processor, the certificate issuing method comprising:
receiving a start signal for issuing a certificate of the battery from the terminal of the user;
setting a mission progress status, which is for issuing the certificate, based on battery data acquired from the vehicle; and
providing at least a portion of a notification associated with issuing the certificate and the certificate to the terminal of the user based on the mission progress status.

14. A non-transitory computer-readable recording medium in which a program for executing the certificate issuing method of claim 13 on a computer is recorded.
